# EUROPÄISCHE PATENTSCHRIFT

(11) **EP 1 537 057 B1**
(45) Veröffentlichungstag und Bekanntmachung des Hinweises auf die Patenterteilung: **07.05.2008**
(21) Anmeldenummer: 03757838.2
(22) Anmeldetag: 13.09.2003
(51) Int. Cl.: C03C 17/34, H05B 3/74, C04B 41/45, C23C 16/00, C23C 4/12, C03C 17/36, C23C 14/00

(54) **VERFAHREN ZUR HERSTELLUNG VON SCHICHTEN UND SCHICHTSYSTEMEN SOWIE BESCHICHTETES SUBSTRAT**
METHOD FOR PRODUCING LAYERS AND LAYER SYSTEMS AND COATED SUBSTRATE
PROCEDE DE REALISATION DE COUCHES ET DE SYSTEMES DE COUCHES, ET SUBSTRAT RECOUVERT

(30) Priorität: 14.09.2002 DE 10242848
(43) Veröffentlichungstag der Anmeldung: 08.06.2005
(73) Patentinhaber: Schott AG, 55122 Mainz (DE)
(72) Erfinder: MÖLLE, Christoph, 55131 Mainz (DE); BEWIG, Lars, 37581 Bad Gandersheim (DE); KOPPE, Frank, 37581 Bad Gandersheim (DE); KÜPPER, Thomas, 37581 Bad Gandersheim (DE); GEISLER, Stefan, 37154 Northeim (DE); BAUER, Stefan, 55232 Alzey (DE)
(74) Vertreter: Herden, Andreas F.
(86) Internationale Anmeldenummer: PCT/EP2003/010222
(87) Internationale Veröffentlichungsnummer: WO 2004/026787

(56) Entgegenhaltungen:
- EP-A- 0 516 436
- EP-A- 0 548 972
- US-A- 4 900 630
- US-A- 5 705 277
- US-A- 5 944 964
- KLINGER R E: "EVOLUTION OF SURFACE ROUGHNESS AND SCATTER IN EVAPORATED ZIRCONIA/SILICA MULTILAYER COATINGS" PROCEEDINGS OF THE SPIE, SPIE, BELLINGHAM, VA, US, Bd. 678, 1986, Seiten 41-50, XP002911055 ISSN: 0277-786X

## Beschreibung

Die Erfindung betrifft ein Verfahren zur Herstellung eines Schichtsystemes mit hochwertigen optischen Eigenschaften und/oder hoher Oberflächenglattheit sowie beschichtete Substrate mit hochwertigen optischen Eigenschaften und/oder hoher Oberflächenglattheit.

Verfahren zum Beschichten von Substraten mit insbesondere optischen Schichten zur Herstellungen von optischen Bauteilen wie beispielsweise Spiegel oder Reflektoren sind seit langem bekannt. Die optischen Schichten haben dabei vielfältigste Funktionen hinsichtlich ihrer Wirkung auf die Strahlung innerhalb eines bestimmten Bereiches des elektromagnetischen Spektrums.

Verfahren zum Beschichten von Substraten mit insbesondere optischen Schichtsystemen, die aus mehreren einzelnen Funktionsschichten, insbesondere aus wechselnd angeordneten hoch- und niedrigbrechenden Schichten aufgebaut sind, sind ebenfalls seit Jahren für eine Vielzahl von Anwendungen bekannt. Dabei wirken die Schichtsysteme oftmals als Lichtinterferenzfilm, dessen optische Eigenschaften durch die Wahl des Materials für die hoch- bzw. niedrigbrechenden Schichten und damit der entsprechenden Brechungsindizes, durch die Anordnung der einzelnen Schichten und durch die Wahl der einzelnen Schichtdicken bestimmt sind. Die Auswahl erfolgt im wesentlichen unter Ausnutzung bekannter optischer Designregeln und Designhilfsmittel nach Maßgabe der angestrebten optischen Eigenschaften und der Verarbeitbarkeit.

In den letzten Jahren haben sich hauptsächlich PVD-Verfahren (Physical Vapour Deposition) und CVD-Verfahren (Chemical Vapour Deposition) zur Herstellung von Schichten bzw. Schichtsysteme, insbesondere für optische Schichten und Schichtsystemen, durchgesetzt.

CVD-Verfahren werden zur Herstellung von Schichten aus refraktären und anderen Metallen, Carbiden, Nitriden und Oxiden verwendet. Dem Vorteil, dass viele Materialien mit nahezu theoretischer Dichte und guter Haftfestigkeit, gleichförmig sowie mit großer Reinheit aufgebracht werden können, steht der Nachteil gegenüber, dass nicht für jedes gewünschte Schichtmaterial passende Reaktionen existieren, das Substrat der meist hohen Reaktionstemperatur standhalten und dem Reaktanden gegenüber chemisch stabil sein muss. Im allgemeinen liegen die während der Reaktion erforderlichen Drücke bei 10 bis 100 Pa, so dass die freie Weglänge der Teilchen relativ gering ist und die Beschichtungsraten für industrielle Prozesse nicht optimal sind.

Die PVD-Verfahren, insbesondere Sputterverfahren, zeichnen sich heute demgegenüber dadurch aus, dass eine Vielfalt an beschichtbaren Substratmaterialien möglich ist, dass es eine nahezu uneingeschränkte Auswahl an Beschichtungsmaterialien gibt, dass die Wahl der Substrattemperatur frei ist, dass die Schichthaftung hervorragend ist und dass die Mikrostruktur der Schichten durch die Wahl der Prozessparameter einfach zu beeinflussen ist. Die Nachteile der ursprünglich entwickelten Sputterverfahren wurden durch vielfältige Entwicklungen weitgehend behoben, so dass die Sputtertechnologie heute zu den universellsten und am weitesten verbreiteten Beschichtungsverfahren zu zählen ist.

Für industrielle Beschichtungsverfahren haben sich in den letzten Jahren durch den Einsatz und die Weiterentwicklung von Magnetron-Sputterquellen besonders die Magnetron-Sputterverfahren als geeignet erwiesen. Die Magnetron-Sputterverfahren ermöglichen hohe Beschichtungsraten im niedrigen Druckbereich (bis unter 0,1Pa) bei geringer Substraterwärmung.

Grundsätzlich ist dem Fachmann die Verfahrensweise des Sputterns bekannt.

Mittels einer Sputtervorrichtung, wie sie beispielsweise in der DE 41 06 770 beschrieben wird, werden Substrate mit Hilfe der Kathodenzerstäubung, vorzugsweise durch Magnetronkathodenzerstäubung beschichtet. Dabei werden sogenannte Targets aus dem Schichtausgangsmaterial der Einwirkung einer zwischen zwei Elektroden sich ausbildenden Plasmawolke ausgesetzt, wobei das Target gleichzeitig die Kathode bildet. Das zerstäubte Targetmaterial besitzt eine Affinität zum Reaktivgas und schlägt sich, mit diesem eine chemische Verbindung bildend, als Schicht auf dem Substrat nieder.

In der EP 0 516 436 B1 ist eine Magnetron-Sputteranlage zum Beschichten eines Substrates mit einer oder mehreren Schichten beschrieben.

Die spezielle Form der Anlage trägt zu einem effizienteren Sputterprozess bei. Die Anlage weist dazu eine Vakuumkammer auf, in der sich ein trommelförmiger Substrathalter und an den Wandungen der Vakuumkammer Targets aus den Schichtausgangsmaterialien befinden, wobei die Targets auf Magnetrons angeordnet sind.

Durch das Drehen der Trommel auf der sich die Substrate befinden, werden diese gleichmäßig beschichtet. Auch bewirkt diese Form des Sputterns, dass die Substrate mit mehreren Schichten beschichtet werden können, ohne aus der Vakuumkammer genommen zu werden und die Dicke der Schicht einfach zu beeinflussen ist.

Es hat sich jedoch gezeigt, dass mit den bekannten Sputterverfahren zur Beschichtung von Substraten mit insbesonderen optischen Schichten und Schichtsystemen noch immer Qualitätsmängel in Form von Trübungen und verhältnismäßig starker Rauhigkeit der Schichtoberflächen auftreten, die bei Beleuchtung des beschichteten Substrates meist als Bereiche mit diffuser Lichtstreuung zu erkennen sind. Neben einem rein kosmetischen Effekt bewirken Trübungen eine Verringerung des Reflexionsgrades der Beschichtung und damit der Güte von Reflexionsoptiken. Bei Filteroptiken führen diese Trübungen zu einer Verminderung des Transmissionsgrades. In beiden Fällen kann neben dem Effekt der Lichtstreuung auch eine erhöhte Absorption zur Verminderung der Produktqualität beitragen.

Die US 5 944 964 (Solberget al.) zeigt ein Verfahren zum Aufbringen von Wechselschichtsystemen bei welchen eine Zirkonoxidschicht von einer Siliziumoxidschicht unterbrochen wird.

Die Erfindung hat sich die Aufgabe gestellt, ein Verfahren zum Beschichten von Substraten bereitzustellen, mit dem Schichten und Schichtsysteme aufgebracht werden, welche eine hohe optische Güte und/oder eine hohe Oberflächenglattheit aufweisen, sowie beschichtete Substrate mit hoher optischer Güte und/oder hoher Oberflächenglattheit zur Verfügung zu stellen.

Diese Aufgabe wird bereits in höchst überraschender Weise durch ein Verfahren gemäß der Ansprüche 1 bis 7, einem beschichteten Substrat gemäß der Ansprüche 8 bis 11 und durch die Verwendung eines Beschichtete Substrats nach Anspruch 12 gelöst.

Dementsprechend umfasst das erfindungsgemäße Verfahren zum Beschichten eines Substrates mit mindestens einer Funktionsschicht, das Bereitstellen eines Substrates in einem Vakuumsystem sowie das Bereitstellen des Schichtausgangsmaterials in diesem Vakuumsystem und das Beschichten des Substrats mittels Sputtern des Schichtausgangsmaterials, bei welchem der Sputterprozess zum Beschichten des Substrates mit der Funktionsschicht zumindest einmal unterbrochen wird, wobei eine im Verhältnis zur Funktionsschicht sehr dünne, von der Funktionsschicht verschiedene Zwischenschicht aufgebracht wird, die unter einer Dicke von 20 nm bleibt.

Als Sputtern werden solche Prozesse bezeichnet, bei denen die Schichtausgangsmaterialien, die in fester Form als Target vorliegen, dem Beschuss von Ionen ausgesetzt werden, so dass es zur Emission von Atomen, Atomclustern oder Molekülen des Targets und somit zu einem Zerstäuben des Schichtausgangsmaterials kommt.

Die hier im weiteren benannten Funktionsschichten können optisch wirksame (d.h. diese haben eine Funktionen hinsichtlich ihrer Wirkung auf die Strahlung innerhalb eines bestimmten Bereiches des elektromagnetischen Spektrums) Einzelschichten einer Beschichtung sein. Dabei kann die Beschichtung sowohl aus nur einer Funktionsschicht als auch aus mehreren Funktionsschichten, beispielsweise einem Interferenzschichtsystem aus hoch- und niedrig brechenden Funktionsschichten bestehen.

Das hier beschriebene Verfahren zum Beschichten eines Substrates mit mindestens einer Funktionsschicht beeinflußt in vorteilhafter Weise weder die Konstruktion bekannter Anlagen noch die bekannten Sputterprozesse als solche, sondern gibt einen neuen Verfahrensablauf für die Herstellung von Funktionsschichten vor, wodurch deren Qualität wesentlich verbessert werden kann. Es müssen hierzu keine Änderungen an sich bekannten Anlagen durchgeführt werden sondern lediglich der Prozessablauf gemäß des erfindungsgemäßen Verfahrens mit an sich bekannten Mitteln neu organisiert werden. Das Verfahren ist nicht auf bestimmte Sputteranlagen begrenzt, sondern auf jede Anlagenform, die das Sputtern von Schichtausgangsmaterialien ermöglicht, übertragbar.

Als besonders vorteilhaft hat sich das Magnetronsputtern herausgestellt, da höhere Sputterraten erzielt werden können als mit anderen Sputterverfahren und somit ein wirtschaftlicher Vorteil gegeben ist.

Die Zwischenschichten weisen in Abhängigkeit von der Dicke der Funktionsschicht eine Dicke von 0,1 nm - 20 nm, bevorzugt 0,5 nm - 10 nm, besonders bevorzugt 1 nm - 3 nm auf und sind optisch nicht wirksam, dass heißt sie bleiben in jedem Fall unter einer Dicke, bei welcher sie im betrachteten Bereich des elektromagnetischen Spektrums eine merklichen Änderungen der Spektralkurve hervorrufen.

Die nach diesem Verfahren hergestellten Funktionsschichten erscheinen brillanter und glatter und bewirken eine Erhöhung des Transmissionsgrades und/oder Reflexionsgrades.

Das erfindungsgemäße Verfahren ist zum Beschichten eines Substrats mit einer Metallschicht vorgesehen, insbesondere einer Funktionsschicht aus Chrom.
Die Unterbrechung der Funktionsschicht aus Metall, insbesondere aus Chrom, erfolgt hier durch die Einkopplung eines sauerstoffreichen Mikrowellenplasmas, das mittels eines Mikrovawe Applicator erzeugt werden kann.
Dabei wird der Prozess des Sputterns von reinen Metall-Targets bzw. den Cr-Targets, kurzzeitig unterbrochen und der Mikrovawe Applicator aktiviert, was dazu führt, dass Sauerstoff in das Vakuum eingebracht wird. Dieser Sauerstoff reagiert mit der auf dem Substrat bereits aufgebrachten Metallschicht zu einer dünnen Metalloxidschicht und bildet somit eine sehr dünne Zwischenschicht. Anschließend wird mit dem Sputtern der Metall- bzw. Crom-Targets fortgefahren. Derart hergestellte Schichten haben eine deutlich glattere Oberfläche, was ebenfalls zu besseren optischen Eigenschaften beiträgt, sowie für die weitere Verarbeitung.

Die Erfinder haben herausgefunden, dass dieses Verfahren dazu führt, dass die gemessene Rauhigkeit einer nach diesem Verfahren hergestellten Oberfläche einer Chromschicht nur etwa halb so groß ist, wie sie bei einer polierten Edelstahlmatritze gemessen wurde, einem bisher bevorzugten Verfahren zur Erzeugung hochpolierter elektrisch leitfähiger Oberflächen.

Jeder dieser vorgenannten Beschichtungsvorgänge ist beliebig oft wiederholbar, um mehrere Funktionsschichten mit Zwischenschichten zu erhalten, wobei es nicht notwendigerweise erforderlich ist, dass jede Funktionsschicht mittels einer Zwischenschicht unterbrochen wird.

Vorteilhafterweise werden die Substrate auf einer Trommel, die sich innerhalb der Vakuumkammer befindet, angebracht und rotieren an den Targets mit den Schichtausgangsmaterialien und an der Sauerstoffquelle vorbei. Hierdurch ist eine homogene Beschichtung gewährleistet.

Es liegt für den Fachmann nahe, dass ebenfalls andere, geeignete Vorrichtungen zur Beschichtung verwendet werden können.

Die Erfindung umfasst, neben dem erfindungsgemäßen Verfahren ein beschichtetes Substrat mit mindestens einer Funktionsschicht aus einem Metall, bei welchem die Funktionsschicht mindestens einmal durch eine Zwischenschicht unterbrochen wird, wobei die Zwischenschicht aus einem Metalloxid besteht und unter einer Dicke von 10 nm bleibt.

Besonders für Substrate, deren Funktionsschicht eine Chromschicht ist, hat es sich als positiv für die Glattheit der Oberfläche herausgestellt, wenn diese mittels einer Zwischenschicht aus einem Metalloxid, insbesondere mittels einer Chromoxidschicht unterbrochen wird.

Derart beschichtete Substrate mit Chrom finden beispielsweise Verwendung als Substrate für lithgrafische Prozesse.

Da derart gestaltete Beschichtungen von Substraten die bereits erwähnten guten optischen Eigenschaften aufweisen, finden sie in vielen Bereichen Verwendung.

Derartig beschichtete Substrate sind nicht an bekannte Sputter-Verfahren gekoppelt und deren Herstellung ist auch mit anderen Verfahren, beispielsweise mit CVD-Verfahren denkbar.

Die hier offenbarten Verfahren stellen lediglich mögliche, vorteilhafte Verfahren dar, mit denen erfindungsgemäße beschichtete Substrate herstellbar sind.

Die Erfindung wird nachfolgend genauer anhand bevorzugter Ausführungsformen und unter Bezugnahme auf die beigefügten Figuren näher erläutert. Dabei verweisen gleiche Bezugszeichen in den Figuren auf gleiche oder ähnliche Teile.

Es zeigen:
- Fig. 2:: Eine schematische Darstellung einer Magnetron-Sputtereinrichtung zum Beschichten von Substraten mit Cr.
- Fig. 3:: Eine schematische Darstellung eines Querschnitts durch ein Schichtsystem gemäß einer Ausführungsform der Erfindung

Die Darstellungen sind nicht maßstabsgetreu; die Dicke der Schichten und die Relation der Schichtdicken zueinander ist grundsätzlich für den jeweiligen Anwendungsfall frei wählbar.

### Beispielhafte Ausführungsformen

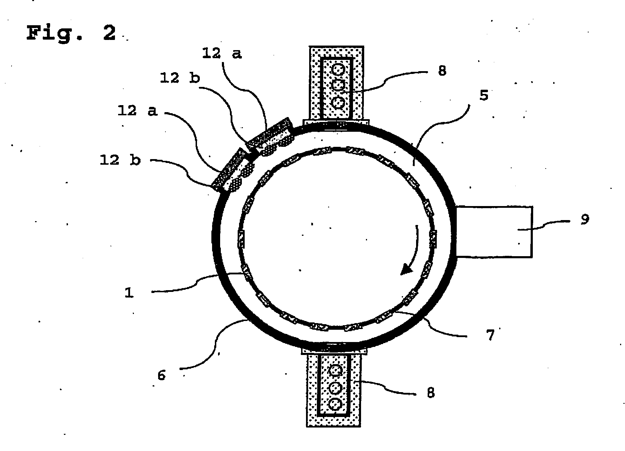

Figur 2 zeigt eine schematisch dargestellte Magnetron-Sputtereinrichtung.

Der grundsätzliche Aufbau einer solchen Magnetron-Sputtereinrichtung ist aus der EP 0 516 436 B1 bekannt, weshalb im folgenden auf eine detaillierte Beschreibung verzichtet wird.

Innerhalb der Vakuumkammer (5) befindet sich eine Trommel (7), auf der die einzelnen zu beschichteten Substrate (1) befestigt sind. Des weiteren verfügt die dargestellte Magnetron-Sputtereinrichtung an ihrer kreisförmigen Wandung (6) in diesem Ausführungsbeispiel über eine pumpe (9) und zwei Mikrowellengeneratoren (8). Es hat sich gezeigt, dass die in der EP 0 516 436 B1 beschriebe Anlage sich gut für die erfindungsgemäße Beschichtung eines Substrats eignet, jedoch ist das Verfahren nicht nur auf diese beschränkt, sondern auch auf anderen Sputteranlagen durchführbar.

Die Magnetron-Sputteranlage dient zum erfindungemäßen Herstellen von Chromschichten für lithografische Prozesseauf Substraten und verfügt über zwei Sputterelektodeneinheiten (12 a).

Die Substrate (1) werden auf der Trommel (7) innerhalb der Vakuumkammer (5) bereitgestellt. Zum Aufbringen einer ersten Funktionsschicht aus Chrom auf ein Substrat (1) werden durch metallisches Sputtern der Cr-Targets (12 b) Cr-Atome in die Vakuumkammer (5) eingebracht.

Hierbei ist entscheidend, dass sich in der Vakuumkammer (5) kein Sauerstoff befindet oder zugeführt wird. Der Sputterprozess wird so lange durchgeführt, bis die gewünschte Dicke der Chromschicht, hier 30 nm erreicht ist. Dann werden die Sputterelektodeneinheiten (12 a) ausgeschaltet und ein kurzzeitiges Aktivieren des Mikrowellengeneratoren (8) erfolgt, wodurch ein Sauerstoffplasma in der Vakuumkammer (5) entsteht, das die frisch gesputterte metallische Chromoberfäche anoxidiert. Die Dicke der dabei entstehenden Oxidschicht ist so dünn, dass sie keinen Einfluß auf die spektralen Eigenschaften, insbesondere die Reflexionseigenschaften der Spiegelschicht hat.

Nach diesem Vorgang wird der Mikrowellengeneratoren (8) ausgeschaltet und erneut die Sputterelektodeneinheiten (12 a) aktiviert und es erfolgt erneut das Aufbringen einer weiteren Chromschicht von ca. 30 nm durch metallisches Sputtern der Cr-Targets (12 b). Diese Verfahrensweise wird so oft wiederholt, bis die gewünschte Gesamtdicke von 270 nm erreicht ist.

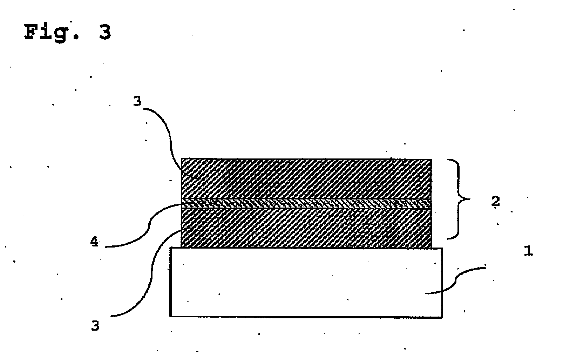

Figur 3 zeigt schematisch ein nach dem oben beschriebenen Verfahren beschichtetes Substrat mit einer Funktionsschicht (2). Hierbei ist auf dem Substrat (1) eine erste Hälfte einer Funktionsschicht (3) aufgebracht worden, dann erfolgt die Unterbrechung mit einer Zwischenschicht (4) und darauf die zweite Hälfte einer Funktionsschicht (3). Je nach Anwendungsfall und Vorgabe des optischen Design liegt es durchaus nahe, mehrere derart geteilte, auch unterschiedliche Funktionsschichten (2) übereinander aufzubringen.

## Patentansprüche

1. Verfahren zum Beschichten eines Substrates (1) mit mindestens einer Funktionsschicht (2), umfassend
a) das Bereitstellen des Substrates (1) und des Schichtausgangsmaterials in einem Vakuumsystem (5) und
b) das Beschichten des Substrates (1) mit einer Funktionsschicht (2) mittels Sputtern des Schichtausgangsmaterials
b1) **wobei** das Sputtern des Schichtausgangsmaterials zum Beschichten des Substrates (1) mit einer Funktionsschicht (2) zumindest einmal unterbrochen wird und eine von der Funktionsschicht verschiedene Zwischenschicht (4) erzeugt wird, deren Dicke ≤ 20 nm beträgt,
b2) das Sputtern des Schichtausgangsmaterials nach der Unterbrechung fortgesetzt wird, **dadurch gekennzeichnet, dass** als Funktionsschicht (2) durch Sputtern eines Metalles eine Metallschicht aufgebracht wird.

2. Verfahren zum Beschichten eines Substrates (1) nach Anspruch 1, **dadurch gekennzeichnet, dass** das Beschichten des Substrates (1) mit einer Funktionsschicht (2) mittels Magnetron-Sputtern des Schichtausgangsmaterials aufgebracht wird.

3. Verfahren zum Beschichten eines Substrates (1) nach Anspruch 2, **dadurch gekennzeichnet, dass** die Funktionsschicht mittels eines Magnetron-Sputterverfahren mit einer Sputteranlage die eine Vakuumkammer aufweist, in der sich ein trommelhaltiger Substrathalter und an den Wandungen der Vakuumskammer Targets aus den Schichtausgangsmaterialien befinden, aufgebracht wird.

4. Verfahren zum Beschichten eines Substrates (1) nach einem der Ansprüche 1 bis 3, **dadurch gekennzeichnet, dass** eine reine Metallschicht aufgebracht wird.

5. Verfahren zum Beschichten eines Substrates (1) nach einem der Ansprüche 1 bis 4, **dadurch gekennzeichnet, dass** die Unterbrechung des Sputterns der Funktionsschicht (2) durch die Einkopplung eines sauerstoffreichen Mikrowellenplasma in die Vakuumkammer erfolgt, wobei eine Zwischenschicht (4) aus Metalloxid durch Oxidation der Oberfläche der bisher aufgewachsenen Funktionsschicht (2) aus Metall entsteht.

6. Verfahren zum Beschichten eines Substrates (1) mit einer Funktionsschicht (2) nach Anspruch 5, **dadurch gekennzeichnet, dass** die Funktionsschicht (2) mittels Sputtern von Chrom aufgebracht wird.

7. Verfahren zum Beschichten eines Substrates (1) nach einem der vorhergehenden Ansprüche, **dadurch gekennzeichnet, dass** die Substrate (1) auf einer Trommel (7), die sich innerhalb der Vakuumkammer befindet, an Targets (10, 11, 12) mit den Schichtausgangsmaterialien und einer Sauerstoffquelle (8) vorbei rotieren.

8. Beschichtetes Substrat (1) mit mindestens einer Funktionsschicht (2) aus einem Metall, **dadurch gekennzeichnet, dass** die Funktionsschicht (2) mindestens eine sie unterbrechende Zwischenschicht (4) aus einem Metalloxid aufweist, deren Dicke ≤ 10 nm beträgt.

9. Beschichtetes Substrat (1) nach Anspruch 8, **dadurch gekennzeichnet, dass** die Funktionsschicht (2) eine Chromschicht ist.

10. Beschichtetes Substrat (1) nach einem der Ansprüche 8 oder 9, **dadurch gekennzeichnet, dass** die unterbrechende Zwischenschicht (4) aus einem Metalloxid eine Chromoxidschicht ist.

11. Beschichtetes Substrat (1), nach einem der Ansprüche 8 bis 10, **dadurch gekennzeichnet, dass** dieses herstellbar mit einem Verfahren gemäß der Ansprüche 1 bis 7 ist.

12. Vervendung eines beschichtete Substrats nach einem der Ansprüche 8 bis 11 für lithografische Prozesse.

## Claims

1. Method for coating a substrate (1) with at least one functional layer (2), comprising:
a) the provision of the substrate (1) and the layer starting material in a vacuum system (5) and
b) the coating of the substrate (1) with a functional layer (2) by sputtering the layer starting material,
b1) wherein the sputtering of the layer starting material for the coating of the substrate (1) with a functional layer (2) is interrupted at least once and an intermediate layer (4) which is different from the functional layer is formed, the thickness of which is ≤ 20 nm,
b2) the sputtering of the layer starting material is continued after the interruption, **characterised in that** a metal layer is applied as a functional layer (2) by sputtering a metal.

2. Method for coating a substrate (1) according to claim 1, **characterised in that** the coating of the substrate (1) with a functional layer (2) is realised through magnetron sputtering of the layer starting material.

3. Method for coating a substrate (1) according to claim 2, **characterised in that** the functional layer is applied through a magnetron sputtering process with a sputtering installation which comprises a vacuum chamber, in which there is a drum-holding substrate holder and targets of the layer starting material on the walls of the vacuum chamber.

4. Method for coating a substrate (1) according to one of the claims 1 to 3, **characterised in that** a pure metal layer is applied.

5. Method for coating a substrate (1) according to one of the claims 1 to 4, **characterised in that** the interruption of the sputtering of the functional layer (2) is realised through the incoupling of an oxygen-rich microwave plasma into the vacuum chamber, whereby an intermediate layer (4) of metal oxide is produced through oxidation of the surface of the functional layer (2) of metal formed so far.

6. Method for coating a substrate (1) with a functional layer (2) according to claim 5, **characterised in that** the functional layer (2) is applied by sputtering chromium.

7. Method for coating a substrate (1) according to one of the preceding claims, **characterised in that** the substrates (1) on a drum (7) which is within the vacuum chamber rotate past targets (10, 11, 12) with the layer starting materials and an oxygen source (8).

8. Coated substrate (1) with at least one functional layer (2) of a metal, **characterised in that** the functional layer (2) comprises at least one intermediate layer (4) of a metal oxide interrupting it, of which the thickness is ≤ 10 nm.

9. Coated substrate (1) according to claim 8,
**characterised in that** the functional layer (2) is a chromium layer.

10. Coated substrate (1) according to one of the claims 8 or 9, **characterised in that** the interrupting intermediate layer (4) of metal oxide is a chromium oxide layer.

11. Coated substrate (1) according to one of the claims 8 to 10, **characterised in that** this can be produced with a method according to claims 1 to 7.

12. Use of a coated substrate according to one of the claims 8 to 11 for lithographic processes.

## Revendications

1. Procédé de revêtement d'un substrat (1) avec au moins une couche de fonction (2), comportant :
a) la mise à disposition du substrat (1) et de la matière de revêtement de départ dans un système sous vide (5), et
b) le revêtement du substrat (1) avec une couche de fonction (2) au moyen de crépitement de la matière de revêtement de départ,
b1) le crépitement de la matière de revêtement de départ pour le revêtement du substrat (1) avec une couche de fonction (2) étant interrompu, au moins une fois, et une couche intermédiaire (4) différente de la couche de fonction étant engendrée, dont l'épaisseur est ≤ 20 nm,
b2) le crépitement de la matière de revêtement de départ étant poursuivi après l'interruption, **caractérisé en ce que**, en tant que couche de fonction (2), une couche métallique est appliquée par crépitement d'un métal.

2. Procédé de revêtement d'un substrat (1) selon la revendication 1, **caractérisé en ce que** le revêtement du substrat (1) avec une couche de fonction (2) est appliqué au moyen de crépitement par magnétrons de la matière de revêtement de départ.

3. Procédé de revêtement d'un substrat (1) selon la revendication 2, **caractérisé en ce que** la couche de fonction est appliquée au moyen d'un procédé de crépitement par magnétrons dans une installation de crépitement, comportant une chambre sous vide dans laquelle se trouvent un porte-substrat en forme de tambour et des cibles en matières de revêtement de départ positionnées sur les parois de la chambre sous vide.

4. Procédé de revêtement d'un substrat (1) selon l'une des revendications 1 à 3, **caractérisé en ce qu'**une couche en métal pur est appliquée.

5. Procédé de revêtement d'un substrat (1) selon l'une des revendications 1 à 4, **caractérisé en ce que** l'interruption du crépitement de la couche de fonction (2) est effectuée par l'admission dans la chambre sous vide d'un plasma à micro-ondes riche en oxygène, moyen par lequel une couche intermédiaire (4) en oxyde métallique est engendrée par oxydation de la surface de la couche de fonction (2) en métal déposée auparavant.

6. Procédé de revêtement d'un substrat (1) avec une couche de fonction (2) selon la revendication 5, **caractérisé en ce que** la couche de fonction (2) est appliquée au moyen de crépitement de chrome.

7. Procédé de revêtement d'un substrat (1) selon l'une des revendications précédentes, **caractérisé en ce que** les substrats (1) positionnés sur un tambour (7), qui se trouve à l'intérieur de la chambre sous vide, passent par rotation à coté des cibles (10, 11, 12) en matières de revêtement de départ et d'une source d'oxygène (8).

8. Substrat (1) revêtu avec au moins une couche de fonction (2) en un métal, **caractérisé en ce que** la couche de fonction (2) comporte au moins une couche intermédiaire (4) en un oxyde métallique l'interrompant, dont l'épaisseur est ≤ 10 nm.

9. Substrat (1) revêtu selon la revendication 8, **caractérisé en ce que** la couche de fonction (2) est une couche de chrome.

10. Substrat (1) revêtu selon l'une des revendications 8 ou 9, **caractérisé en ce que** la couche intermédiaire (4) d'interruption en un oxyde métallique est une couche d'oxyde de chrome.

11. Substrat (1) revêtu selon l'une des revendications 8 à 10, **caractérisé en ce que** celui-ci peut être fabriqué avec un procédé selon les revendications 1 à 7.

12. Utilisation d'un substrat revêtu selon l'une des revendications 8 à 11 pour des processus lithographiques.
